(19) Europäisches Patentamt / European Patent Office / Office européen des brevets

(11) **EP 4 550 048 A1**

(12) **EUROPEAN PATENT APPLICATION**
published in accordance with Art. 153(4) EPC

(43) Date of publication:
07.05.2025   Bulletin 2025/19

(21) Application number: 23830864.7

(22) Date of filing: 15.05.2023

(51) International Patent Classification (IPC):
*G03F 7/30* (2006.01)    *B41C 1/00* (2006.01)
*G03F 7/00* (2006.01)    *G03F 7/027* (2006.01)

(52) Cooperative Patent Classification (CPC):
B41C 1/00; G03F 7/00; G03F 7/027; G03F 7/30

(86) International application number:
PCT/JP2023/018117

(87) International publication number:
WO 2024/004412 (04.01.2024 Gazette 2024/01)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority:   30.06.2022   JP 2022106393

(71) Applicant: **TOYOBO MC Corporation**
**Osaka 530-0001 (JP)**

(72) Inventor: **YAMADA, Hiroto**
**Okayama-shi, Okayama 704-8194 (JP)**

(74) Representative: **Müller-Boré & Partner**
**Patentanwälte PartG mbB**
**Friedenheimer Brücke 21**
**80639 München (DE)**

(54) **DEVELOPMENT BRUSH, DEVELOPMENT DEVICE, FLEXOGRAPHIC PRINTING PLATE PRODUCTION METHOD, AND LIGHT-SENSITIVE RESIN FLEXOGRAPHIC PRINTING ORIGINAL PLATE DEVELOPMENT METHOD**

(57)   An object of the present invention is to provide a development brush that satisfies all the following three elements, **i.e.,** satisfaction of desired development speed and image reproducibility, and a long period of maintaining the performance, a developing device, a method for producing a flexographic printing plate, and a method for developing a photosensitive resin flexographic printing plate precursor. A development brush 1 to be rubbed with a photosensitive resin flexographic printing plate precursor 2 so as to remove, for development, an uncured portion of photosensitive resin from the photosensitive resin flexographic printing plate precursor, wherein the development brush has a plurality of brush bristles implanted on a base material 22, wherein each of the plurality of brush bristles has a diameter of 80 to 250 μm, and wherein the development brush has a density of brush bristles of 22% or more and 37% or less, wherein the density is defined by a proportion of a cross-sectional area of the plurality of brush bristles to an area of a surface of the base material in which the plurality of brush bristles are implanted.

[FIG. 3]

FIG. 3

EP 4 550 048 A1

**Description**

Technical Field of the Invention

The present invention relates to a development brush, a developing device, a method for producing a flexographic printing plate, and a method for developing a photosensitive resin flexographic printing plate precursor.

Background Art

As to a method for producing a printing plate by forming irregularities on a photosensitive resin layer stacked on a surface of a support, a method for exposing a photosensitive resin layer formed using a photosensitive composition to UV light via an original drawing film or the like, selectively curing an image portion, and removing an uncured portion with a developer is well known (for example, see Patent Document 1) .

Regarding a developing method, there are requirements of improving the development speed and the image reproducibility, and a brush developing method, a spray developing method, a brush and spray combined developing method (for example, see Patent Document 2), and the like are being studied.

Prior Art Documents

Patent Documents

Patent Document 1: Japanese Patent Application Laid-Open (JP-A) No. 83072/94
Patent Document 2: Japanese Patent Application Laid-Open (JP-A) No. 2010-117623

Disclosure of the Invention

Problem that the Invention is to Solve

However, these conventional techniques have not been studied on the period of maintaining the performance thereof.

The present invention has been made in view of these circumstances. An object of the present invention is to provide a development brush that satisfies at high level all the following three elements, i.e., satisfaction of desired development speed and image reproducibility, and a long period of maintaining the performance (hereinafter, it may also be referred to as a "brush life"), a developing device, a method for producing a flexographic printing plate, and a method for developing a photosensitive resin flexographic printing plate precursor.

Means for Solving the Problem

As a result of earnest studies, the inventors of the present invention have found that the problems can be solved by the means described below, and have arrived at the present invention. That is, the present invention can include the following aspects of the invention.

[1] A development brush to be rubbed with a photosensitive resin flexographic printing plate precursor so as to remove, for development, an uncured portion of photosensitive resin from the photosensitive resin flexographic printing plate precursor,

wherein the development brush has a plurality of brush bristles implanted on a base material,
wherein each of the plurality of brush bristles has a diameter of 80 to 250 $\mu$m, and
wherein the development brush has a density of brush bristles of 22% or more and 37% or less, wherein the density is defined by a proportion of a cross-sectional area of the plurality of brush bristles to an area of a surface of the base material in which the plurality of brush bristles are implanted.

[2] The development brush according to [1], wherein each of the plurality of brush bristles has a length from an end which is not implanted in the base material to the base material of 10 mm or more and 25 mm or less.
[3] The development brush according to [1], wherein a material for the plurality of brush bristles is a polyester resin and/or a polyamide resin, and/or an olefin resin.

[4] A developing device for removing, using the development brush according to any of [1] to [3], an uncured portion from a photosensitive resin flexographic printing plate precursor.

[5] The developing device according to [4], wherein a brush pressure of the development brush applied during development of the photosensitive resin flexographic printing plate precursor is 0.5 to 5 mm.

[6] A method for producing a flexographic printing plate, comprising the step of producing a flexographic printing plate by rubbing a photosensitive resin flexographic printing plate precursor with a brush so as to remove an uncured portion of photosensitive resin from the photosensitive resin flexographic printing plate precursor, wherein the brush has a plurality of brush bristles implanted on a base material, wherein each of the plurality of brush bristles has a diameter of 80 to 250 μm, and wherein the brush has a density of brush bristles of 22% or more and 37% or less, wherein the density is defined by a proportion of a cross-sectional area of the plurality of brush bristles to an area of a surface of the base material in which the plurality of brush bristles are implanted.

[7] A method for developing a photosensitive resin flexographic printing plate precursor, comprising the step of removing, for development, an uncured portion of photosensitive resin from the photosensitive resin flexographic printing plate precursor by rubbing the photosensitive resin flexographic printing plate precursor with a brush, wherein the brush has a plurality of brush bristles implanted on a base material, wherein each of the plurality of brush bristles has a diameter of 80 to 250 μm, and wherein the brush has a density of brush bristles of 22% or more and 37% or less, wherein the density is defined by a proportion of a cross-sectional area of the plurality of brush bristles to an area of a surface of the base material in which the plurality of brush bristles are implanted. Advantages of the Invention

According to the present invention, it is possible to provide a development brush that satisfies desired development speed and image reproducibility and further has a long brush life of maintaining the performance, a developing device, a method for producing a flexographic printing plate, and a method for developing a photosensitive resin flexographic printing plate precursor.

Brief Description of the Drawings

FIG. 1 is a diagram illustrating one example of the configuration of a batch-type developing machine that has a brush according to the first embodiment and is used for development of a photosensitive resin plate.

FIG. 2 is a diagram illustrating one example of the configuration of an inline-type developing machine that has a brush according to the first embodiment and is used for development of a photosensitive resin plate.

FIG. 3 is a diagram illustrating, as a basic pattern, one example of the configuration of the brush according to the first embodiment.

FIG. 4 is a diagram for explaining the length of brush bristles of the brush according to the first embodiment.

FIG. 5 is a diagram for explaining the density of brush bristles of the brush according to the first embodiment.

FIG. 6 is a diagram illustrating, as a zigzag pattern, other example of the configuration of the brush according to the first embodiment.

FIG. 7 is a diagram illustrating, as a modified zigzag pattern, another example of the configuration of the brush according to the first embodiment.

Mode for Carrying Out the Invention

Hereinafter, embodiments of the present application are described with reference to the drawings. The following embodiments are just suitable application examples, and the application range of techniques of the present invention is not to be limited to these embodiments. In the present specification, an identical sign may be given to constituent elements having the same function. However, these constituent elements are not necessarily identical.

<Developing machine>

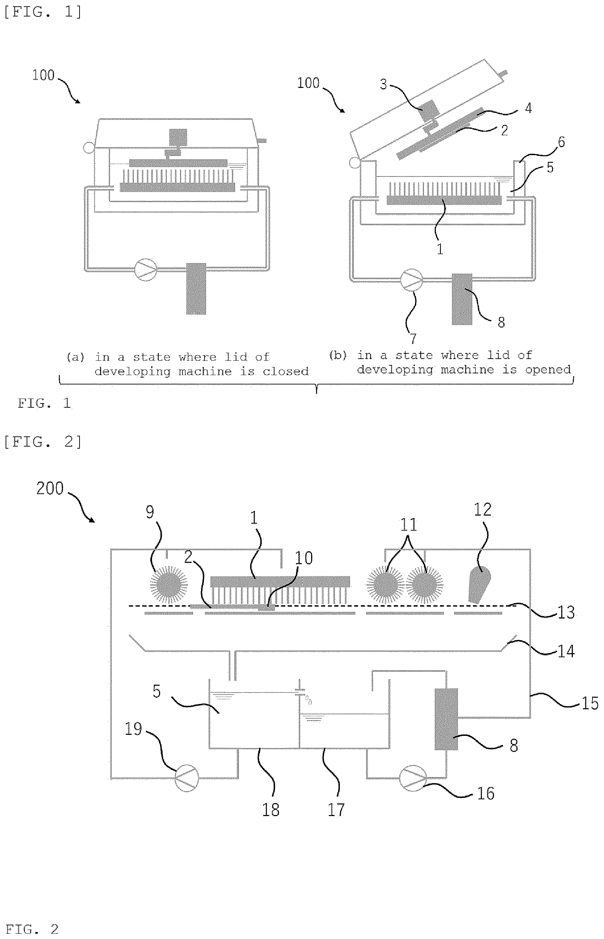

FIG. 1 illustrates one example of the configuration of a batch-type developing machine 100 having a development brush (hereinafter, it may also simply referred to as a "brush") 1 according to the first embodiment. The batch-type developing machine 100 develops a photosensitive resin plate 2, using the brush 1. The photosensitive resin plate that has not been developed may also be referred to as a photosensitive resin plate precursor. The batch-type developing machine 100 comprises, for example, a development brush motor 3, a setter 4, a development tank 6 capable of storing a developer 5, a circulation pump 7, and a filter 8.

With the photosensitive resin plate 2 fixed to the setter 4, the batch-type developing machine 100 makes the brush 1 and the photosensitive resin plate 2 undergo relative rubbing movement in the developer 5 so as to develop the photosensitive resin plate 2, that is, so as to remove an uncured portion of photosensitive resin in the photosensitive resin plate 2. As a result of the development, a printing plate is produced from the photosensitive resin plate 2. The rubbing movement may be performed with the developer 5 poured onto the brush 1 and the photosensitive resin plate 2, instead of in the developer 5. The rubbing movement is realized by making the brush 1 and/or the setter 4 undergo rotational movement and/or translation movement. FIG. 1 illustrates an example of the case in which the setter 4 is made to undergo the rotational movement and/or the translation movement by the development brush motor 3. The batch-type developing machine 100 employs a batch system in which a photosensitive resin plate 2 that has been developed for a prescribed time is removed from the setter 4 and a new photosensitive resin plate 2 is fixed for the next development. In the development, a portion of photosensitive resin in the photosensitive resin plate 2 that has not been cured in a preceding exposing step is removed. FIG. 1 illustrates an example of a representative batch-type developing machine. However, the configuration of a batch-type developing machine that can have the brush 1 according to the first embodiment is not limited to the one illustrated in FIG. 1. It is desired to circulate the developer 5 by the circulation pump 7 on a continuous basis. This is because such circulation does not allow the photosensitive resin dispersed in the developer 5 to be separate and enables homogenization of the concentration of resin in the developer 5. Making the developer 5, which is circulated by the circulation pump 7, pass through the filter 8 is further desired so as to enable removal of debris floating in the developer 5. The debris is photosensitive resin cured by exposure but peeled from the plate due to the curing being insufficient, and a solid formed by the developer 5 being dried in the platemaker.

FIG. 2 illustrates one example of the configuration of an inline-type developing machine 200 having the brush 1 according to the first embodiment. The inline-type developing machine 200 also develops a photosensitive resin plate 2, using the brush 1. The inline-type developing machine 200 comprises, for example, a filter 8, a prewash brush 9, a conveying pin bar 10, a rinse brush 11, an air knife 12, a conveying chain 13, a developer receiver 14, rinse liquid piping 15, a filter pump 16, a concentration tank 17, a development tank 18 capable of storing a developer 5, and a developer pump 19.

Similarly to the batch-type developing machine 100, the inline-type developing machine 200 also makes the brush 1 and the photosensitive resin plate 2 undergo relative rubbing movement in the presence of the developer 5 so as to develop the photosensitive resin plate 2. In contrast with the batch-type developing machine, the inline-type developing machine 200 is a developing device characterized by being capable of continuously developing photosensitive resin plates 2. FIG. 2 illustrates an example of a representative inline-type developing machine. However, the configuration of an inline-type developing machine that can have the brush 1 according to the first embodiment is not limited to the one illustrated in FIG. 2. By making a hole in a plurality of locations at an end of the photosensitive resin plate 2, and inserting the hole into a pin of the conveying pin bar 10, the photosensitive resin plate 2 is fixed to the conveying pin bar 10. By hooking the conveying pin bar 10 on the conveying chain 13 of the developing machine, and conveying the conveying chain 13, the inline-type developing machine 200 conveys the photosensitive resin plate 2 from the head to the rear of the inline-type developing machine 200. In the inline-type developing machine 200, the prewash brush 9, the development brush 1, the rinse brush 11, and the air knife 12 are provided in this order from the head toward the rear. Further, an exposure device may be provided before and after the order.

The prewash brush 9 is in the shape of a roll and removes a surface layer, i.e., a mask layer, of the photosensitive resin plate 2 by rotating the roll. The mask layer includes, for example, a protective layer and an infrared sensitive layer. The development brush 1 serves to develop the photosensitive resin plate 2. Specifically, by conveying the photosensitive resin plate 2 at a prescribed speed while making the brush 1 and the photosensitive resin plate 2 undergo relative rubbing movement in the developer 5, the photosensitive resin plate 2 is developed. The rubbing movement may be performed with the developer 5 poured onto the brush 1 and the photosensitive resin plate 2, instead of in the developer 5. The rubbing movement is realized by making the brush 1 undergo rotational movement and/or translation movement. The rubbing movement may also be realized by making the conveying pin bar 10 undergo translation movement, in addition to or instead of the rotational movement and/or the translation movement of the brush 1. In the development, a portion of photosensitive resin in the photosensitive resin plate 2 that has not been cured in a preceding exposing step is removed. The developer 5 used in the development is stored in the development tank 18. The developer circulated from the development tank 18 by the developer pump 19 is used during the removal of the mask layer by the prewash brush and/or the development using the development brush 1.

The rinse brush 11 is in the shape of a roll and rubs the photosensitive resin plate 2 by rotating the roll, and removes debris left in the plate while a developer having a lower concentration of resin than the concentration of resin of the developer 5 used in the development, a new developer, or water is poured onto the photosensitive resin plate 2. The air knife 12 narrowly blows supplied air and blows away water on the photosensitive resin plate 2 to the forward side in the conveyance direction so as to drain off the water. The filter 8 is a cross-flow filter membrane that has a bore of, for example, 0.05 to 10 $\mu$m. A part of the developer 5 used in the development and stored in the development tank 18 is transferred to the concentration tank 17. The developer in the concentration tank 17 is transferred by the filter pump 16 and made to pass through the filter 8. A filtrate is transferred to the rinse liquid piping 15, while a developer having a high concentration of resin is returned to the concentration tank 17 and circulated. By using such a dense filter membrane, a developer to be used with the rinse brush 11 is made from the developer 5 used in the development. The use of the developer produced as described above is more excellent than the use of a new developer in that the yield of developer waste can be reduced. When water is used for the removal of debris by the rinse brush 11, a drainage mechanism that does not allow water to be mixed in the developer 5 is utilized.

The case of using the conveying pin bar 10 for the conveyance of the photosensitive resin plate 2 has been illustrated as an example. In addition to this case, however, as the inline-type developing machine having the brush 1 according to the first embodiment, a developing machine may also be used which has applied thereto, for example, a belt conveyor-type comprising a belt conveyor to which the photosensitive resin plate 2 can be fixed, or a setter-type in which the photosensitive resin plate 2 is attached and fixed to a setter plate and the setter plate is conveyed by a nip roll or a chain. The transferring method is not particularly specified as long as the photosensitive resin plate 2 is provided with a rigid structure on a rear surface thereof and can be transferred from the front to the rear of the developing device.

<Development brush>

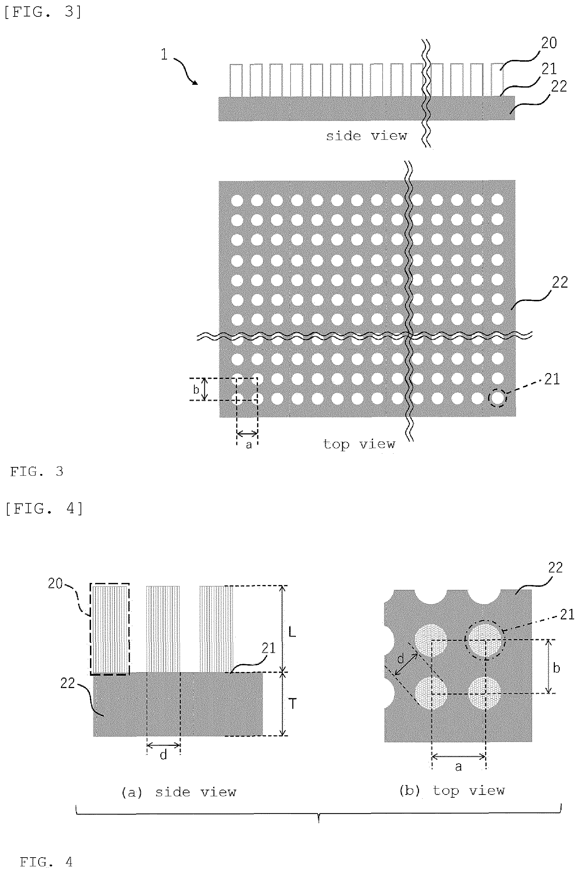

FIG. 3 illustrates one example of the configuration of the brush 1 according to the first embodiment. Hereinafter, the brush 1 is described using the following two axis directions in parallel with a surface of the base material of the brush 1 in which brush bristles are implanted. An X-axis direction can be designated as the depth direction in FIG. 1 in the case of a batch-type device, and as the direction perpendicular to the plate transferring direction in the case of an inline-type device. Further, a Y-axis direction can be designated as the horizontal direction in FIG. 1 in the case of a batch-type device, and as the plate transferring direction in the case of an inline-type device.

The brush 1 comprises a plurality of brush bristle bundles 20 and a base material (hereinafter, it may also be referred to as a "brush base material") 22. The brush 1 is produced, for example, by regularly providing a plurality of brush holes 21 on the base material 22, and implanting brush bristles of a brush bristle bundle 20 in each of the holes 21. There are various methods for implanting the brush bristles. Representative examples of the methods include a mechanical knocking method for knocking a brush bristle, which has been folded in two, in the base material 22 with thin metal wire, a hand-stitch method for pulling a brush bristle, which has been folded in two, from the back side of a hole with yarn or wire and fixing the brush bristle, and an ultrasonic method for directly knocking a brush bristle bundle 20 in a hole of the base material 22 and fixing the brush bristle bundle 20 through ultrasonic fusion. The brush 1 may be produced by any method.

A material for the brush bristles of the brush bristle bundles 20 is, for example, generally a resin monofilament, and a polyester resin and/or a polyamide resin and/or an olefin resin is optimal. Also usable are vinyl chloride, acrylic, a fluorine fiber, animal hair such as hose hair and pig hair, plant fibers such as hemp and palm, and filaments made from metals such as copper and brass. The cross-sectional shape of a surface of the brush bristles in parallel with the surface of the base material 22 in which the brush bristles are implanted is generally circular. However, there are brush bristles having various shapes such as an oval, a triangle, a rectangle, and a star shape, and brush bristles having any one of the shapes are usable.

The diameter of the brush bristles is measured by measuring the diameter of the cross-section. When the shape of the cross-section is not circular, the diameter of a circle having the identical area to the area of the cross-section can be referred to as the diameter of the brush bristles in the present specification. The diameter is preferably 80 to 250 $\mu$m, more preferably 90 to 240 $\mu$m, further preferably 110 to 220 $\mu$m and furthermore preferably 150 to 180 $\mu$m. For example, with a decrease in the diameter from the above lower limit, the development speed becomes lower, and/or the brush bristles are more likely to be spread, whereas, with an increase in the diameter from the above upper limit, the development speed becomes higher but the reproducibility of a fine image is deteriorated. From these viewpoints, a preferable range of the diameter of the brush bristles is designed. As to the diameter, a range can be selected which has, as the lower limit and the upper limit, any two values selected from the group consisting of 80 $\mu$m, 90 $\mu$m, 100 $\mu$m, 110 $\mu$m, 120 $\mu$m, 130 $\mu$m, 140 $\mu$m, 150 $\mu$m, 160 $\mu$m, 170 $\mu$m, 180 $\mu$m, 190 $\mu$m, 200 $\mu$m, 210 $\mu$m, 220 $\mu$m, 230 $\mu$m, 240 $\mu$m, and 250 $\mu$m.

In the example of FIG. 3, the plurality of brush holes 21 are provided in the base material 22 in a regular pattern, which is referred to as a basic pattern in the present specification. The basic pattern is, as illustrated in FIG. 3, a pattern in which the brush holes 21 are arranged with equal intervals in the horizontal direction of the brush 1. More specifically, the pattern is as follows. The base material 22 has a plurality of brush holes 21, for example, with equal intervals in the X-axis direction. The base material 22 further has such a plurality of brush holes 21 with equal intervals in the Y-axis direction. That is, the basic pattern has a pattern of the brush holes 21 that has a repeating unit with a pitch of certain length in the X-axis direction (hereinafter, it may also be referred to as a "brush hole pitch X") and a pitch of certain length in the Y-axis direction (hereinafter, it may also be referred to as a "brush hole pitch Y"). In the example of FIG. 3, "a" represents the brush hole pitch X and "b" represents the brush hole pitch Y.

FIG. 4 is a diagram for explaining a length L of the brush bristles (hereinafter, it may also be referred to as a "brush bristle length") of the brush bristle bundles 20 in the brush 1 according to the first embodiment.

The brush bristle length L is the length from the tips of the brush bristles to the surface of the base material 22 in which the brush bristles are implanted. The brush bristles having a brush bristle length L of 3 mm or more and 50 mm or less are usable. The brush bristle length is preferably 7 mm or more and 30 mm or less, more preferably 10 mm or more and 25 mm or less, and further preferably 12 mm or more and 20 mm or less. For example, with a decrease in the brush bristle length L from the above lower limit, the development speed becomes higher, but the brush bristles are more likely to be spread, and/or the reproducibility of a fine image is deteriorated, whereas, with an increase in the brush bristle length L from the above upper limit, the development speed becomes lower. From these viewpoints, a preferable range of the brush bristle length is designed. As to the brush bristle length L, a range can be selected which has, as the lower limit and the upper limit, any two values selected from the group consisting of 3 mm, 7 mm, 10 mm, 12 mm, 14 mm, 16 mm, 18 mm, 20 mm, 25 mm, 30 mm and 50 mm.

A diameter "d" of the brush holes 21 (hereinafter, it may also be referred to as a "brush hole diameter") is the diameter of the brush holes 21 provided in the brush base material 22 and is measured by measuring the diameter of the brush bristle bundles 20 completed. The shape of the brush holes 21 is generally circular. However, the brush holes 21 can have various shapes such as an oval, a triangle, a rectangle, and a star shape. In the measurement of the diameter of a brush hole 21 whose shape is not circular, the diameter of a circle having the identical area to the area of the brush hole 21 can be referred to as the diameter of the brush hole 21 in the present specification.

The brush base material 22 may be made from any material as long as the material is not affected by the developer and not deformed. The brush base material 22 is generally made from vinyl chloride, DURACON, nylon, polyethylene, polypropylene, polycarbonate, polyethylene terephthalate, FRP, wood, a metal, or the like. Conceivable examples of the shape of the base material 22 include a quadrangular prism, a column, and a triangular prism, but any shape can be applied without any problem, as long as the implantation surface of the brush is a flat surface. There is no particular limitation to a thickness T of the base material 22, and a thickness in a range that causes no practical problem is selected. The thickness T is generally set to 30 mm or less in many cases.

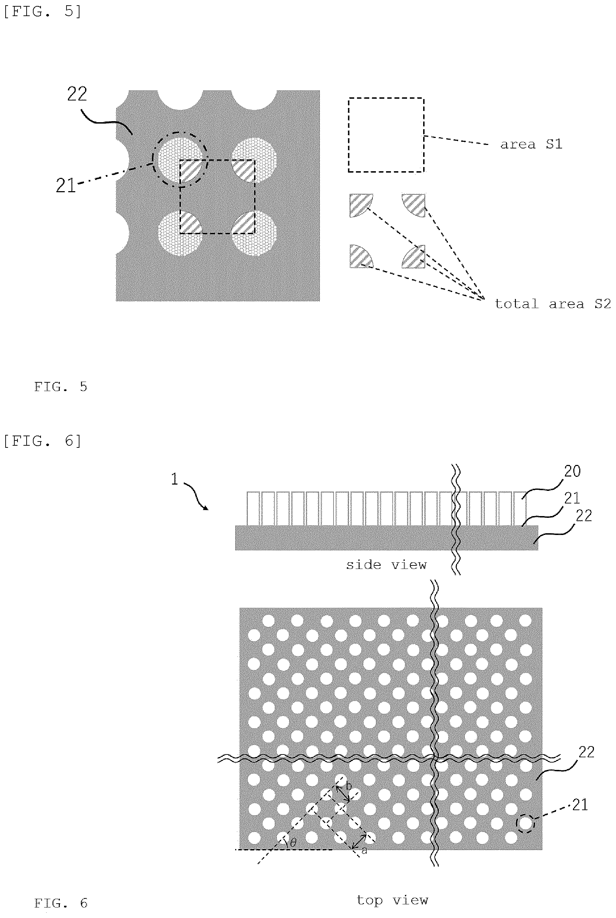

FIG. 5 is a diagram for explaining the density of brush bristles of the brush 1 according to the first embodiment. FIG. 5 illustrates the repeating unit of the basic pattern illustrated in FIG. 3.

The density of brush bristles is defined by a proportion of the cross-sectional area of these brush bristles to the area of the surface of the brush base material 22 in which these brush bristles are implanted. More specifically, the density of brush bristles in the present specification is a proportion of a unit brush area S2 occupied by brush holes 21 in a unit area S1 of the brush base material 22 to the unit area S1 illustrated in FIG. 5.

A calculation equation of the proportion is as follows.

[Equation 1]

$$\text{density of brush bristles [\%]} = \frac{\text{unit brush area [mm}^2\text{]}}{\text{unit area [mm}^2\text{]}} \times 100$$

A value of the density of brush bristles is preferably 22% or more and 37% or less, more preferably 24% or more and 33% or less, and further preferably 26% or more and 30% or less. For example, with a decrease in the density of brush bristles from the above lower limit, the development speed becomes lower, whereas, with an increase in the density of brush bristles from the above upper limit, the development speed becomes higher but clogging of resin is more likely to occur. From these viewpoints, a preferable range of the density of brush bristles is designed. As to the density of brush bristles, a range can be selected which has, as the lower limit and the upper limit, any two values selected from the group consisting of 22%, 23%, 24%, 25%, 26%, 27%, 28%, 29%, 30%, 31%, 32%, 33%, 34%, 35%, 36% and 37%.

With reference to the example of FIGS. 3 and 4, the density of brush bristles is explained. The unit area can be calculated by $a \times b$. The unit area includes four 1/4 shapes of a brush hole 21, and therefore the unit brush area corresponds to the area of one brush hole 21 and can be calculated by $1/4 \, \pi d^2$.

Heretofore, the case in which the base material 22 has the plurality of brush holes 21 in the basic pattern has been explained with reference to FIGS. 3, 4 and 5. The present embodiment is not limited to this case.

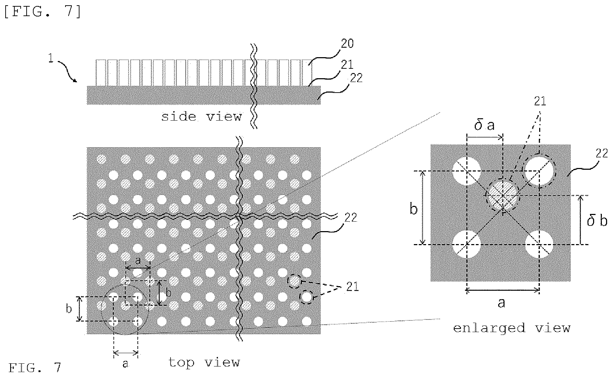

FIGS. 6 and 7 each illustrate another example of the configuration of the brush 1 according to the first embodiment. In the example of FIG. 6, a plurality of brush holes 21 are provided in a base material 22 in a zigzag pattern. In the example of FIG. 7, a plurality of brush holes 21 are provided in a base material 22 in a modified zigzag pattern.

The zigzag pattern in the example of FIG. 6 is a pattern obtained by shifting the angle of the basic pattern as illustrated in FIG. 6. More specifically, the zigzag pattern in the example of FIG. 6 is a pattern obtained by rotating the basic pattern in the example of FIG. 4 by an angle θ (hereinafter, it may also be referred to as an "angle of the brush hole pitch") with the direction perpendicular to the X- and Y-axes used as a rotational axis. The angle θ is greater than 0 degrees and smaller than 90 degrees. A pattern with θ equal to 0 degrees corresponds to the basic pattern. Accordingly, the repeating unit of the zigzag pattern has the same shape as the repeating unit of the basic pattern illustrated in FIG. 5. Accordingly, a unit area and a unit brush area of the zigzag pattern are respectively calculated in the same manner as the unit area S1 and the unit brush area S2 in the example of FIG. 5.

The modified zigzag pattern in the example of FIG. 7 is a pattern obtained by overlapping two basic patterns on top of another as illustrated in FIG. 7. More specifically, the modified zigzag pattern is formed by overlapping of a basic pattern Pa formed of white brush holes 21 and a basic pattern Pb formed of shaded brush holes 21 in FIG. 7. The basic patterns Pa and Pb are formed of the same brush hole pitch X represented by "a" and brush hole pitch Y represented by "b". On the other hand, the basic patterns Pa and Pb are shifted from one another in the X-axis direction by a certain amount of displacement (hereinafter, it may also be referred to as "overlapping displacement pitch X"), and in the Y-axis direction by a certain amount of displacement (hereinafter, it may also be referred to as "overlapping displacement pitch Y"). In the example of FIG. 7, the overlapping displacement pitch X is represented by $\delta a$ and the overlapping displacement pitch Y is represented by $\delta b$. The overlapping displacement pitches $\delta a$ and $\delta b$ can take any numbers satisfying $0 < \delta a < 1/2a$ and $0 < \delta b < 1/2b$, respectively. A pattern with $\delta a$ equal to $1/2a$ and $\delta b$ equal to $1/2b$ corresponds to the zigzag pattern. Accordingly, a unit area of the modified zigzag pattern includes a unit brush area including two brush holes 21, and the unit area is calculated in the same manner as the unit area S1 in the example of FIG. 5, whereas the unit brush area can be calculated by $1/2 \, \pi d^2$, which is double the unit brush area S2 in the example of FIG. 5.

Regarding the development brush 1 explained above, the brush pressure applied during the development of the photosensitive resin plate precursor is explained.

The brush pressure is represented by the distance by which the tips of the brush bristles are compressed in the direction perpendicular to the surface of the base material 22 in which the brush bristles are implanted, as a result of application of pressure to the tips of the brush bristles of the brush 1 to which pressure have not been applied. More specifically, the brush pressure is obtained by measuring, from the structure of the developing machine, the displacement between the position where the tip surfaces of the brush bristles are supposed to be present through the photosensitive resin plate precursor, supposing that the brush bristles of the brush 1 are not bent on the surface of the base material during the development by the developing machine, and the position of the surface of the photosensitive resin plate precursor. The brush pressure is suitably 0.5 to 5 mm, and a brush pressure of 0 mm or more and less than or equal to the brush bristle length L is applicable. A brush pressure of less than 0.5 mm is impracticable because with such a brush pressure, there is a location in which the brush is not uniformly applied. With a brush pressure of more than 5 mm, the reproducibility of a fine image is deteriorated and the spread of the brush is accelerated. From these viewpoints, a preferable range of the brush pressure can be set.

<Photosensitive resin plate precursor>

The photosensitive resin plate precursor for flexographic printing is also referred to as a "photosensitive resin flexographic printing plate precursor" or simply as a "flexographic printing plate precursor" as described below. A plate obtained as a result of development of such a plate precursor is also referred to as a "flexographic printing plate".

The flexographic printing plate precursor is a flexographic printing plate precursor that has, on a support, a photosensitive resin layer obtained from a photosensitive resin composition, and is preferably a water-developable flexographic printing plate precursor for which an aqueous developer is used as a washout solution. A water-developable photosensitive resin composition contains a synthetic rubber polymer, a photopolymerizable unsaturated monomer compound, and a photopolymerization initiator. A developing method is effective when the photosensitive resin layer contains a water-dispersible synthetic rubber polymer, and the effectiveness is not changed when the photosensitive resin layer further contains a water-insoluble synthetic rubber polymer. The photosensitive resin composition may also contain a water-soluble or hydrophilic polymer component therein.

As to the support used for the printing plate precursor, a material that is flexible but has excellent dimensional stability is preferred. Examples of the support include a support made from a metal such as stainless steel, aluminum, copper, and nickel, and thermoplastic resin films such as a polyethylene terephthalate film, a polyethylene naphthalate film, a polybutylene terephthalate film, and a polycarbonate film. Among these examples, a polyethylene terephthalate film that has excellent dimensional stability and sufficiently high viscoelasticity is particularly preferred.

The water-dispersible synthetic rubber polymer to be used for the photosensitive resin composition is used to impart appropriate rubber elasticity to the photosensitive resin layer. A conventionally known rubber component is usable as the synthetic rubber polymer. The water-dispersible synthetic rubber polymer is preferably solid at room temperatures so as to impart rubber elasticity. Specific examples of the water-dispersible synthetic rubber polymer include polybutadiene, polychloroprene, polyacrylonitrile-butadiene, polyacrylic, epichlorohydrin, polyurethane, polyisoprene, a polystyrene-isoprene copolymer, a polystyrene-butadiene copolymer, a methyl methacrylate-butadiene copolymer, an ethylene-propylene copolymer, a butyl polymer, and chlorinated polyethylene, and include polymers obtained by copolymerizing these polymers with another component such as acrylic acid and methacrylic acid. Among these water-dispersible synthetic rubber polymers, a water-dispersible synthetic rubber polymer having a butadiene skeleton and/or a styrene skeleton is preferred in terms of developability and physical properties. The water-dispersible synthetic rubber polymer is preferably water-dispersed latex. The water-dispersed latex may be latex having, in the molecule thereof, a crosslinked structure represented by the degree of gelation. The latex having a crosslinked structure in the molecule thereof is preferably a hydrophobic polymer obtained from water-dispersed latex having a weight-average degree of gelation of 20 to 80%. These polymers may be used singly or in combination of two or more thereof. The water-dispersed latex is a suspension that contains water having fine polymer particles of rubber dispersed therein and is stable. By removing water from this water-dispersed latex, a polymer can be obtained.

The photosensitive resin composition for a flexographic printing plate precursor may contain a water-insoluble synthetic rubber polymer as far as it does not adversely affect the performance of the photosensitive resin composition. Examples of such a water-insoluble elastomer include elastomers such as polybutadiene, polychloroprene, polyacrylonitrile-butadiene, polyurethane, polyisoprene, a polystyrene-isoprene copolymer, and a polystyrene-butadiene copolymer. Among those examples, a water-insoluble elastomer is preferred because it improves the physical properties and water resistance of the photosensitive resin composition.

The photosensitive resin composition for a flexographic printing plate precursor may contain, in addition to the water-dispersible synthetic rubber polymer, a water-soluble or water-dispersible polymer. Examples of the water-soluble or water-dispersible polymer include a water-soluble polyamide and a water-dispersible polyamide that are obtained by introducing a hydrophilic group to a polyamide, a partially saponified polyvinyl acetate and a derivative thereof, and an anionic acrylic polymer.

With use of the photosensitive resin composition for a flexographic printing plate precursor, the water-dispersible synthetic rubber polymer is dispersed in a developer, and therefore, the concentration of polymer in the developer is never sharply increased. In addition, the synthetic rubber polymer is water-dispersible and is therefore suitable for waste liquid treatment performed by centrifugal separation.

The photopolymerizable unsaturated monomer compound to be used for the photosensitive resin composition is contained for crosslinking and curing with UV light. The photopolymerizable unsaturated monomer compound may be a compound having only one ethylenic unsaturated bond, or a compound having two or more ethylenic unsaturated bonds. The photopolymerizable unsaturated monomer compound may contain an oligomer having a photopolymerizable group introduced therein or a polymer having a photopolymerizable group introduced therein. The photopolymerizable unsaturated monomer compound preferably contains one having a common skeleton with the synthetic rubber polymer in terms of compatibility with the synthetic rubber polymer. These photopolymerizable unsaturated monomer compounds are not limited to single use, but may be used in combination.

Specific examples of the ethylenic unsaturated compound having only one ethylenic unsaturated bond include hydroxy group-containing (meth)acrylates such as 2-hydroxyethyl (meth)acrylate, 2-hydroxypropyl (meth)acrylate, 2-hydroxybutyl (meth)acrylate, 3-chloro-2-hydroxypropyl (meth)acrylate, and $\beta$-hydroxy-$\beta$'-(meth)acryloyloxyethyl phthalate; alkyl (meth)acrylates such as propyl (meth)acrylate, butyl (meth)acrylate, isoamyl (meth)acrylate, 2-ethylhexyl (meth)acrylate, lauryl (meth)acrylate, and stearyl (meth)acrylate; phenoxyalkyl (meth)acrylates such as phenoxyethyl acrylate and nonylphenoxyethyl (meth)acrylate; and alkoxyalkylene glycol (meth)acrylates such as ethoxydiethylene glycol (meth)acrylate, methoxytriethylene glycol (meth)acrylate, and methoxydipropylene glycol (meth)acrylate.

Specific examples of the ethylenic unsaturated compound having two or more ethylenic unsaturated bonds include alkyldiol di(meth)acrylates such as 1,9-nonanediol di(meth)acrylate; polyethylene glycol di(meth)acrylates such as diethylene glycol di(meth)acrylate; polypropylene glycol di(meth)acrylates such as dipropylene glycol di(meth)acrylate; poly(meth)acrylates of polyalcohols, such as trimethylolpropane tri(meth)acrylate, pentaerythritol tri(meth)acrylate, pentaerythritol tetra(meth)acrylate, and glycerol tri(meth)acrylate; poly(meth)acrylates obtained through an addition reaction of ethylene glycol diglycidyl ether with an unsaturated carboxylic acid; poly (meth) acrylates obtained through an addition reaction of unsaturated epoxy compounds such as glycidyl (meth)acrylate with a carboxylic acid or an amine; and poly(meth)acrylamides such as methylenebis(meth)acrylamide.

As to the photopolymerization initiator, any photopolymerization initiator can be used as long as the photopolymerization initiator can polymerize a polymerizable unsaturated group by light irradiation. However, a photopolymerization initiator having a function of producing a radical by self-decomposition or hydrogen abstraction through absorption of light is preferably used. Specifically, for example, benzoin alkyl ethers, benzophenones, anthraquinones, benzils, acetophenones, and diacetyls can be used. The photopolymerization initiators may be used not only singly but also in combination of two or more thereof.

The developer used in the present disclosure is an aqueous developer containing water as a main component, and is used to remove a water-dispersible uncured portion of photosensitive resin. A preferable aqueous developer is as follows.

The aqueous developer may contain only water, or may be a water solution having added thereto a development accelerator that can be solved in water. Examples of the development accelerator include a surfactant, an acid, a base, and a salt. In terms of the development speed, it is preferable to add a development accelerator that can be solved in water. As to the development accelerator, commercially available soap or detergent may be used.

Examples of the surfactant include a cationic surfactant, an anionic surfactant, and a nonionic surfactant.

Detailed examples of the surfactant include the various surfactants described above.

Examples of the acid include inorganic acids such as sulfuric acid, nitric acid, and phosphoric acid, and organic acids such as formic acid, acetic acid, oxalic acid, succinic acid, citric acid, maleic acid, and para-toluenesulfonic acid. Examples of the base include lithium hydroxide, sodium hydroxide, potassium hydroxide, and calcium hydroxide.

As to the development accelerator used in the present disclosure, a surfactant, an acid, a base, and a salt may be used in combination. Optimal blending for the development accelerator may be determined according to the components of the photosensitive resin composition.

The aqueous developer may contain, in addition to water, an organic solvent that can be solved in water. Examples of such an organic solvent include methanol, ethanol, isopropyl alcohol, cellosolve, glycerine, ethylene glycol, and polyethylene glycol.

In order to suppress generation of foam, a defoamer may be added. Any water-soluble defoamer may be used, and examples of a component of the defoamer include a higher alcohol, a fatty acid derivative, silica, alumite, and silicone.

Examples

Examples will now be illustrated as hereunder although techniques of the present invention are not limited thereto.

<Production of photosensitive resin plate precursor>

(1) Production of photosensitive resin composition

Photosensitive resin composition A':

A photosensitive resin composition A' was obtained by mixing, in a container, 91 parts by mass of butadiene latex (manufactured by Zeon Corporation, LX111NF, concentration of solid content 55%) as latex, 15 parts by mass of oligobutadiene acrylate (ABU-4 manufactured by kyoeisha Chemical Co., Ltd.: molecular weight 2700) as a photopolymerizable compound, 10 parts by mass of lauryl methacrylate (manufactured by Japan U-Pica Company Ltd., LMA) as a photopolymerizable compound, 10 parts by mass of trimethylolpropane trimethacrylate (manufactured by SANSHIN CHEMICAL INDUSTRY CO., LTD., SAN-ESTER TMP) as a photopolymerizable compound, 1 part by mass of benzil dimethylketal (manufactured by Tokyo Chemical Industry Co., Ltd., 2,2-Dimethoxy-2-phenylacetophenone) as a photopolymerization initiator, 20 parts by mass of PFT-4 manufactured by kyoeisha Chemical Co., Ltd. (polymer having a urethane-urea structure and having a molecular weight of about 20,000, concentration of solid content 25%) as a hydrophilic polymer, 0.1 part by mass of hydroquinone monomethyl ether (manufactured by Tokyo Chemical Industry Co., Ltd., 4-Methoxyphenol) as a polymerization inhibitor, and 9 parts by mass of liquid butadiene (manufactured by Nippon Soda Co., Ltd., B-3000) as a plasticizer, together with 5 parts by mass of toluene (Tokyo Chemical Industry Co., Ltd., Toluene), and subjecting the mixture to kneading at 105°C using a pressure kneader and thereafter to distillation under reduced pressure so as to remove toluene and water.

Photosensitive resin composition B':

Thirty one parts by mass of Nipol LX111NF (manufactured by Zeon Corporation) as solid content of water-dispersed latex, 10 parts by mass of hydroxy-terminated polybutadiene diacrylate (manufactured by OSAKA ORGANIC CHEMICAL INDUSTRY LTD., BAC-45), and 10 parts by mass of an acrylic monomer (1,9-nonanediol dimethacrylate) were mixed and had the water thereof evaporated in a dryer heated to 120°C for 2 hours, so as to give a mixture containing a polymer obtained from the water-dispersed latex and a photopolymerizable monomer. This mixture, 6 parts by mass of butadiene rubber (manufactured by Zeon Corporation, Nipol BR1220), 7 parts by mass (4 parts by mass as solid content) of a surfactant, and 10 parts by mass of a plasticizer were kneaded in a kneader for 45 minutes. Thereafter, 0.2 part by mass of a thermal polymerization inhibitor and 1 part by mass of a photopolymerization initiator were charged into the kneader and kneaded for 5 minutes so as to give a photosensitive resin composition B'.

Photosensitive resin composition C':

A photosensitive resin composition C' was obtained by mixing, in a container, 100 parts by mass of carboxyl modified methyl methacrylate-butadiene latex (manufactured by NIPPON A&L INC., MR174, concentration of solid content 50%) as latex having carboxyl group, 15 parts by mass of oligobutadiene acrylate (ABU-3 manufactured by kyoeisha Chemical Co., Ltd.: molecular weight 2700) as a photopolymerizable compound, 10 parts by mass of lauryl methacrylate as a photopolymerizable compound, 10 parts by mass of trimethylolpropane trimethacrylate as a photopolymerizable compound, 1 part by mass of benzil dimethylketal as a photopolymerization initiator, 20 parts by mass of PFT-3 manufactured by kyoeisha Chemical Co., Ltd. (polymer having a urethane-urea structure and having a molecular weight of about 20,000, concentration of solid content 25%) as a hydrophilic polymer, 0.1 part by mass of hydroquinone monomethyl ether as a polymerization inhibitor, and 9 parts by mass of liquid butadiene as a plasticizer, together with 5 parts by mass of toluene, and subjecting the mixture to kneading at 105°C using a pressure kneader and thereafter to distillation under reduced pressure so as to remove toluene and water.

Photosensitive resin composition D':

A photosensitive resin composition D' was obtained by mixing, in a container, 71 parts by mass of styrene-butadiene latex (manufactured by Zeon Corporation, C4850, concentration of solid content 70%) as latex of a polystyrene-butadiene copolymer, 15 parts by mass of oligobutadiene acrylate (ABU-3 manufactured by kyoeisha Chemical Co., Ltd.: molecular weight 2700) as a photopolymerizable compound, 10 parts by mass of lauryl methacrylate as a photopolymerizable compound, 10 parts by mass of trimethylolpropane trimethacrylate as a photopolymerizable compound, 1 part by mass of benzil dimethylketal as a photopolymerization initiator, 20 parts by mass of PFT-3 manufactured by kyoeisha Chemical Co., Ltd. (polymer having a urethane-urea structure and having a molecular weight of about 20,000, concentration of solid content 25%) as a hydrophilic polymer, 0.1 part by mass of hydroquinone monomethyl ether as a polymerization inhibitor, and 9 parts by mass of liquid butadiene as a plasticizer, together with 5 parts by mass of toluene, and subjecting the mixture to kneading at 105°C using a pressure kneader and thereafter to distillation under reduced pressure so as to remove toluene and water.

(2) Preparation of protective layer coating solution

A protective layer coating solution was prepared by dissolving, in a water-isopropyl alcohol mixed liquid, low-saponification-degree polyvinyl alcohol (PVA405 manufactured by Kuraray Co., Ltd.), a plasticizer (SANFLEX SE270 manufactured by Sanyo Chemical Industries, Ltd., aliphatic polyalcohol-based polyether polyol, concentration of solid content 85%), and NBR latex (SX1503A manufactured by Zeon Corporation, concentration of solid content 42%) so that the weight ratio of solid content therebetween became 35/35/30.

(3) Preparation of infrared sensitive layer coating solution

An infrared sensitive layer coating solution was prepared by dissolving, in a methanol-ethanol-isopropyl alcohol mixed liquid, a carbon black dispersion (AMBK-8 manufactured by ORIENT CHEMICAL INDUSTRIES CO., LTD.) and a copolyamide (PA223 manufactured by TOYOBO Co., Ltd.) so that the weight ratio of solid content therebetween became 63/37.

(4) Preparation of laminate film Y

The infrared sensitive layer coating solution was applied onto a 100-$\mu$m PET film, on both surfaces of which release treatment had been performed, using an appropriate type of bar coater and dried at 120°C for 5 minutes, so as to stack, on the PET film, an infrared sensitive layer having a film thickness of 1.5 $\mu$m. This laminate had an optical density of 2.3. This optical density was measured by black and white transmission densitometer DM-520 (Dainippon Screen Mfg. Co., Ltd.).
Next, the protective layer coating solution was applied onto the infrared sensitive layer using an appropriate type of bar coater and dried at 120°C for 5 minutes, so as to give a laminate film Y having, on the PET film, the infrared sensitive layer having a film thickness of 1.5 $\mu$m and a protective layer having a film thickness of 0.5 $\mu$m, in this order.

(5) Production of photosensitive resin plate precursors A, B, C, and D respectively formed of photosensitive resin compositions A', B', C', and D' and laminate film Y

The photosensitive resin composition A' was disposed on a 125-$\mu$m PET film having a copolyester adhesive applied thereto, and the laminate film Y was laid thereon. The PET film, the photosensitive resin composition A', and the laminate film Y were laminated at 100°C, using a heat pressing machine so as to give a photosensitive resin plate precursor (flexographic printing plate precursor) A formed of the PET support, the adhesive layer, the photosensitive resin layer, the protective layer, the infrared sensitive layer, and the release-treated PET protective film (cover film). The plate had a total thickness of 1.14 mm. Photosensitive resin plate precursors (flexographic printing plate precursors) B to D were prepared by respectively using the photosensitive resin compositions B', C', and D' in place of the photosensitive resin composition A', and performing the same treatment as performed for the photosensitive resin composition A'.

<Method for preparing developer>

An aqueous developer (10 L) was prepared by dissolving sodium oleate (manufactured by NOF CORPORATION, NONSOUL ON-1N) in tap water so that the concentration of sodium oleate becomes 1% of the total of the developer.

<Development test method>

A brush produced by the method described below was placed in a batch-type developing device so that the brush pressure of 2 mm was realized. The photosensitive resin plate precursor having the cover film peeled therefrom was fixed to a setter with double-sided tape. The total amount of the prepared developer was put into a development tank of the batch-type developing device, and the brush position was set so that the head of the brush came to a water depth of 10 mm. The temperature of the developer was adjusted to 40°C by a heater. A circulation pump was operated at a flow rate of 5 L/min whenever the developer was contained. A 30-mesh cartridge filter was used as a filter. A development brush motor rotationally moved the setter at 60 rpm and a radius of 20 mm.

<Method for measuring developing time>

The photosensitive resin plate precursor was developed by closing a lid on the developing machine prepared in the development test method described above, and rotating the setter. The end of the development was determined by visually inspecting whether the adhesive layer stacked on the PET support was exposed by more than or equal to half the entire area. The lid was opened after 5 minutes from the start of the rotation of the setter, and the state of the photosensitive resin plate was inspected. Thereafter, the state was inspected every minute.

<Method for measuring 1% dot-area reproducibility>

Using an exposure device having aligned 30 fluorescent lamps (60W Philips 10R) and having a size of 900 mm $\times$ 1200 mm, the 125-$\mu$m PET support side of the photosensitive resin plate precursor was exposed for 20 seconds to UV light so as to form a base. Thereafter, the photosensitive resin plate precursor had the cover film peeled therefrom and was set in CDI4835 (inline UV-equipped) manufactured by ESKO. Subsequently, a square-shaped evaluation image pattern was drawn on the infrared sensitive layer. The square-shaped evaluation image pattern had been obtained by arranging, with 30 mm intervals, three 20 mm (length) $\times$ 20 mm (width) screen tints each in length and width, nine screen tints in total, each of the screen tints having a screen ruling of 150 LPI, a screen angle of 45 degrees, and a dot area of 1%. Immediately after finishing the drawing, the photosensitive resin plate precursor was exposed to UV light. This photosensitive resin plate precursor was developed by the development test method described above for the time determined by the method, described above, for measuring the developing time. The plate was taken out, and the dotted image was inspected with loupe, and the reproducibility of the screen tint image was checked and evaluated. The evaluation criteria defined the reproducibility as 100% when the dots in all the nine screen tint images were reproduced, as 90% when a dot was missing or damaged in any one of the screen tint images, as 80% when a dot was missing or damaged in two of the screen tint images, and, with the percentage decreased in order, defined the reproducibility as 10% when a dot was missing or damaged in all the nine screen tint images, and as 0% when dots are remarkably missing or damaged.

<Method for evaluating spread of brush>

A brush produced by the method described below was placed in a batch-type developing device so that the brush pressure of 5 mm was realized. A 2-mm-thick NBR plate was fixed to a setter with double-sided tape. The total amount of the prepared developer was put into a development tank of the batch-type developing device, and the brush position was set so that the head of the brush came to a water depth of 10 mm. The temperature of the developer was adjusted to 50°C by a heater. A development brush motor rotationally moved the setter at 60 rpm and a radius of 20 mm. After a lid of the batch-type developing machine was closed and the brush was worn by rotationally moving the setter for 1000 hours in total, the brush was taken out and evaluated as "∘" when the spread of bristle tips was less than 4 mm, as "∆" when the spread of bristle tips was 4 mm or more and less than 7 mm, and as "×" when the spread of bristle tips was 7 mm or more.

<Method for evaluating clogging of resin>

The photosensitive resin plate precursor that was unexposed was attached to a setter and developed by the development test method described above for the time determined by the method, described above, for measuring the developing time. Development of successive 10 photosensitive resin plate precursors was continuously performed in the same manner. Thereafter, the brush was taken out from the development tank and the brush bristles were observed. The clogging of resin was evaluated as "×" when attachment of resin fragments was found between the brush bristles, as "∆" when resin fragments were found but easily flowed away, and as "o" when no resin fragments were found.

[Example 1]

A brush was made by implanting, in a 300 mm (length) × 210 mm (width) × 10 mm (thickness) vinyl chloride plate except for the 5-mm periphery thereof, nylon 6 (manufactured by Toray Monofilament Co., Ltd., nylon 120T 0.170W) as brush bristles, in the basic pattern with a brush hole diameter of 2 mm, a brush hole pitch X of 3.3 mm, and a brush hole pitch Y of 3.4 mm, and cutting the brush bristles to a brush bristle length of 17 mm. The brush has a density of brush bristles of 28% in calculation. This brush was placed in the developing machine and evaluated by the methods described above. Table 1 shows the evaluation results. All of the performances such as development speed (represented by the developing time), reproducibility of a fine image (represented by the 1% dot-area reproducibility) and a brush life (represented by the spread of the brush and the clogging of resin) were found to be high-level.

[Other Examples]

As Examples 2 to 14, the results of the experiments performed in the same manner as in Example 1 are described. Table 1 collectively shows the detailed conditions and results. Nylon 6 shown in Table 1 is the same nylon 120T manufactured by Toray Monofilament Co., Ltd. as used in Example 1. As nylon 610, nylon 200T manufactured by Toray Monofilament Co., Ltd. was used. As PBT, Polyseter PBT monofilament manufactured by K.R. Plastic Industries co., LTD. was used. As PP, Polyseter Polypropylene monofilament manufactured by K.R. Plastic Industries co., LTD. was used. As nylon 66, Nylone 66 monofilament manufactured by K.R. Plastic Industries co., LTD. was used.

[Table 1]

| | Example 1 | Example 2 | Example 3 | Example 4 | Example 5 | Example 6 | Example 7 | Example 8 | Example 9 |
|---|---|---|---|---|---|---|---|---|---|
| photosensitive resin plate precursor | A | A | A | A | A | A | A | A | A |
| material for brush bristles | Nylon 6 | Nylon 6 | Nylon 6 | Nylon 6 | Nylon 6 | Nylon 6 | Nylon 6 | Nylon 6 | Nylon 6 |
| diameter of brush bristles [$\mu$m] | 170 | 90 | 240 | 170 | 170 | 170 | 170 | 170 | 170 |
| length from tips of brush bristles to base material [mm] | 17 | 17 | 17 | 11 | 24 | 17 | 17 | 8 | 27 |
| brush hole diameter [mm] | 2 | 2 | 2 | 2 | 2 | 2 | 3 | 2 | 2 |
| brush hole pitch X [mm] | 3.3 | 3.3 | 3.3 | 3.3 | 3.3 | 3. 7 | 4.6 | 3.3 | 3.3 |
| brush hole pitch Y [mm] | 3.4 | 3.4 | 3.4 | 3.4 | 3.4 | 3. 7 | 4.6 | 3.4 | 3.4 |
| density of brush bristles [%] | 28 | 28 | 28 | 28 | 28 | 23 | 33 | 28 | 28 |
| developing time [minute] | 9 | 13 | 7 | 7 | 13 | 13 | 7 | 6 | 14 |
| 1% dot-area reproducibility [%] | 100 | 100 | 90 | 90 | 100 | 100 | 90 | 80 | 100 |
| spread of brush | o | o | o | o | o | o | o | Δ | o |
| clogging of resin | o | o | o | o | o | o | o | o | o |

| | Example 10 | Example 11 | Example 12 | Example 13 | Example 14 | Example 15 | Example 16 | Example 17 | Example 18 |
|---|---|---|---|---|---|---|---|---|---|
| photosensitive resin plate precursor | A | A | A | A | B | C | D | A | A |
| material for brush bristles | Nylon 610 | Nylon 66 | PBT | PP | Nylon 6 | Nylon 6 | Nylon 6 | Nylon 6 | Nylon 6 |
| diameter of brush bristles [$\mu$m] | 170 | 170 | 170 | 170 | 170 | 170 | 170 | 90 | 240 |
| length from tips of brush bristles to base material [mm] | 17 | 17 | 17 | 17 | 17 | 17 | 17 | 17 | 17 |
| brush hole diameter [mm] | 2 | 2 | 2 | 2 | 2 | 2 | 2 | 2 | 3 |
| brush hole pitch X [mm] | 3.3 | 3.3 | 3.3 | 3.3 | 3.3 | 3.3 | 3.3 | 3. 7 | 4. 6 |
| brush hole pitch Y [mm] | 3.4 | 3.4 | 3.4 | 3.4 | 3.4 | 3.4 | 3.4 | 3. 7 | 4. 6 |
| density of brush bristles [%] | 28 | 28 | 28 | 28 | 28 | 28 | 28 | 23 | 33 |
| developing time [minute] | 8 | 9 | 8 | 9 | 10 | 7 | 12 | 14 | 6 |
| 1% dot-area reproducibility [%] | 100 | 100 | 90 | 100 | 100 | 100 | 100 | 100 | 80 |
| spread of brush | o | o | o | o | o | o | o | o | o |
| clogging of resin | o | o | o | o | o | o | o | o | o |

As shown in Table 1, in all the examples, the performances such as development speed corresponding to the developing time, 1% dot-area reproducibility, and a brush life (the spread of the brush and the clogging of resin) were found to be high-level or acceptable-level. More specifically, the performances are as follows.

Examples 2 and 3 were performed by changing the diameter of the brush bristles from 170 $\mu$m in Example 1. In both the cases with the diameter of the brush bristles set to 90 $\mu$m and 240 $\mu$m, respectively, all of the development speed, the 1% dot-area reproducibility, and the brush life are high-level. Examples 4 and 5 were performed by changing the length of the brush bristles from 17 mm in Example 1. In both the cases with the length of the brush bristles set to 11 mm and 24 mm, respectively, all of the development speed, the 1% dot-area reproducibility, and the brush life are high-level. Examples 6 and 7 were performed by changing the brush hole diameter and/or the brush hole pitches X and Y so that the density of brush bristles was changed from 28% in Example 1. In both the cases with the density of the brush bristles set to 23% and 33%, respectively, all of the development speed, the 1% dot-area reproducibility, and the brush life are high-level.

Example 8 was performed by changing the length of the brush bristles from 17 mm in Example 1 to 8 mm that is shorter than the length in Example 4. In this case, the brush bristles are more likely to be spread than in the other examples, lowering the 1% dot-area reproducibility. However, these results are acceptable-level. Example 9 was performed by changing the length of the brush bristles from 17 mm in Example 1 to 27 mm that is longer than the length in Example 5. In this case, the developing time is prolonged compared with other examples. However, this result is acceptable-level.

Examples 10, 11, 12, and 13 were performed by changing the material for the brush bristles from nylon 6 in Example 1. With any of the materials for the brush bristles, i.e., nylon 610, nylon 66, PBT, and PP, all of the development speed, the 1% dot-area reproducibility, and the brush life are high-level. Examples 14, 15, and 16 were performed by changing the photosensitive resin plate precursor used, from the photosensitive resin plate precursor A in Example 1. With use of any of the photosensitive resin plate precursors B, C, and D, all of the development speed, the 1% dot-area reproducibility, and the brush life are high-level.

Example 17 was performed by changing the brush hole pitches X and Y so that the density of brush bristles was changed from 28% in Example 2 to 23%. In this case, the developing time is prolonged compared with Example 2. However, this result is acceptable-level. Example 18 was performed by changing the brush hole diameter as well as the brush hole pitches X and Y so that the density of brush bristles was changed from 28% in Example 3 to 33%. In this case, the developing time is further shortened compared with Example 3, but the 1% dot-area reproducibility is lowered. However, this result is acceptable-level.

[Comparative Examples]

As Comparative Examples 1 to 6, the results of the experiments performed in the same manner as in Example 1 are described. Table 2 collectively shows the detailed conditions and results.

[Table 2]

|  | Comparative Example 1 | Comparative Example 2 | Comparative Example 3 | Comparative Example 4 |
|---|---|---|---|---|
| photosensitive resin plate precursor | A | A | A | A |
| material for brush bristles | Nylon 6 | Nylon 6 | Nylon 6 | Nylon 6 |
| diameter of brush bristles [$\mu$m] | 70 | 295 | 170 | 170 |
| length from tips of brush bristles to base material [mm] | 17 | 17 | 17 | 17 |
| brush hole diameter [mm] | 2 | 2 | 2 | 3 |
| brush hole pitch X [mm] | 3.3 | 3.3 | 4 | 4.2 |
| brush hole pitch Y [mm] | 3.4 | 3.4 | 4 | 4.3 |
| density of brush bristles [%] | 28 | 28 | 20 | 39 |
| developing time [minute] | 17 | 6 | 16 | 6 |
| 1% dot-area reproducibility [%] | 100 | 60 | 100 | 80 |

(continued)

|  | Comparative Example 1 | Comparative Example 2 | Comparative Example 3 | Comparative Example 4 |
|---|---|---|---|---|
| spread of brush | Δ | ○ | ○ | ○ |
| clogging of resin | ○ | ○ | ○ | × |

Comparative Example 1 was performed by changing the diameter of the brush bristles from 170 μm in Example 1 to 70 μm that is smaller than the diameter in Example 2. The performance of this case is inferior to the performance of the examples in that the developing time is prolonged in the development of the photosensitive resin plate precursor A. In addition, although within an acceptable range, the brush is more likely to be spread. Comparative Example 2 was performed by changing the diameter of the brush bristles from 170 μm in Example 1 to 295 μm that is larger than the diameter in Example 3. This case has a shorter developing time, but the performance of this case is inferior to the performance of the examples in that the numerical value of the 1% dot-area reproducibility is lowered. Comparative Example 3 was performed by increasing the brush hole pitches X and Y so that the density of brush bristles was decreased from 28% in Example 1 to a density smaller than the density in Example 6. In this case, the density of brush bristles is 20%. The performance of this case is inferior to the performance of the examples in that the developing time is prolonged in the development of the photosensitive resin plate precursor A. Comparative Example 4 was performed by changing the brush hole diameter as well as the brush hole pitches X and Y so that the density of brush bristles was increased from 28% in Example 1 to a density larger than the density in Example 7. In this case, the density of brush bristles is 39%. The performance of this case is inferior to the performance of the examples in that the developing time is shortened, but clogging of resin is more likely to occur.

Explanation of Reference Number

[0081]

100: batch-type developing machine
1: development brush
2: photosensitive resin plate
3: development brush motor
4: setter
5: developer
6: development tank
7: circulation pump
8: filter
200: inline-type developing machine
9: prewash brush
10: conveying pin bar
11: rinse brush
12: air knife
13: conveying chain
14: developer receiver
15: rinse liquid piping
16: filter pump
17: concentration tank
18: development tank
19: developer pump
20: brush bristle bundles
21: brush holes
22: base material

## Claims

1. A development brush to be rubbed with a photosensitive resin flexographic printing plate precursor so as to remove, for development, an uncured portion of photosensitive resin from the photosensitive resin flexographic printing plate precursor,

wherein the development brush has a plurality of brush bristles implanted on a base material,
wherein each of the plurality of brush bristles has a diameter of 80 to 250 $\mu$m, and
wherein the development brush has a density of brush bristles of 22% or more and 37% or less, wherein the density is defined by a proportion of a cross-sectional area of the plurality of brush bristles to an area of a surface of the base material in which the plurality of brush bristles are implanted.

2. The development brush according to claim 1, wherein each of the plurality of brush bristles has a length from an end which is not implanted in the base material to the base material of 10 mm or more and 25 mm or less.

3. The development brush according to claim 1, wherein a material for the plurality of brush bristles is a polyester resin and/or a polyamide resin, and/or an olefin resin.

4. A developing device for removing, using the development brush according to any of claims 1 to 3, an uncured portion from a photosensitive resin flexographic printing plate precursor.

5. The developing device according to claim 4, wherein a brush pressure of the development brush applied during development of the photosensitive resin flexographic printing plate precursor is 0.5 to 5 mm.

6. A method for producing a flexographic printing plate, comprising the step of producing a flexographic printing plate by rubbing a photosensitive resin flexographic printing plate precursor with a brush so as to remove an uncured portion of photosensitive resin from the photosensitive resin flexographic printing plate precursor, wherein the brush has a plurality of brush bristles implanted on a base material, wherein each of the plurality of brush bristles has a diameter of 80 to 250 $\mu$m, and wherein the brush has a density of brush bristles of 22% or more and 37% or less, wherein the density is defined by a proportion of a cross-sectional area of the plurality of brush bristles to an area of a surface of the base material in which the plurality of brush bristles are implanted.

7. A method for developing a photosensitive resin flexographic printing plate precursor, comprising the step of removing, for development, an uncured portion of photosensitive resin from the photosensitive resin flexographic printing plate precursor by rubbing the photosensitive resin flexographic printing plate precursor with a brush, wherein the brush has a plurality of brush bristles implanted on a base material, wherein each of the plurality of brush bristles has a diameter of 80 to 250 $\mu$m, and wherein the brush has a density of brush bristles of 22% or more and 37% or less, wherein the density is defined by a proportion of a cross-sectional area of the plurality of brush bristles to an area of a surface of the base material in which the plurality of brush bristles are implanted.

[FIG. 1]

(a) in a state where lid of
    developing machine is closed

(b) in a state where lid of
    developing machine is opened

FIG. 1

[FIG. 2]

FIG. 2

[FIG. 3]

FIG. 3

[FIG. 4]

(a) side view  (b) top view

FIG. 4

[FIG. 5]

22

21

area S1

total area S2

FIG. 5

[FIG. 6]

1

20
21
22

side view

22

21

FIG. 6

top view

[FIG. 7]

side view

top view

FIG. 7

enlarged view

## INTERNATIONAL SEARCH REPORT

International application No.

**PCT/JP2023/018117**

### A. CLASSIFICATION OF SUBJECT MATTER

*G03F 7/30*(2006.01)i; *B41C 1/00*(2006.01)i; *G03F 7/00*(2006.01)i; *G03F 7/027*(2006.01)i
FI:    G03F7/30 501; G03F7/00 502; B41C1/00; G03F7/027 502

According to International Patent Classification (IPC) or to both national classification and IPC

### B. FIELDS SEARCHED

Minimum documentation searched (classification system followed by classification symbols)

G03F7/30; B41C1/00; G03F7/00; G03F7/027

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2010-117623 A (TOYO BOSEKI) 27 May 2010 (2010-05-27)<br>claims, paragraph [0011], example 1 | 1-7 |
| Y | JP 11-133626 A (TOYO BOSEKI) 21 May 1999 (1999-05-21)<br>paragraph [0003] | 1-7 |
| Y | JP 2020-79840 A (MISATO MIRAI 21 LTD) 28 May 2020 (2020-05-28)<br>paragraph [0091] | 1-7 |
| A | JP 2003-107684 A (FUJI PHOTO FILM CO LTD) 09 April 2003 (2003-04-09)<br>claims | 1-7 |
| A | JP 58-159533 A (TORAY KK) 21 September 1983 (1983-09-21)<br>claims | 1-6 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **31 May 2023** | **11 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/018117**

| Patent document cited in search report | | | Publication date (day/month/year) | Patent family member(s) | Publication date (day/month/year) |
|---|---|---|---|---|---|
| JP | 2010-117623 | A | 27 May 2010 | (Family: none) | |
| JP | 11-133626 | A | 21 May 1999 | (Family: none) | |
| JP | 2020-79840 | A | 28 May 2020 | (Family: none) | |
| JP | 2003-107684 | A | 09 April 2003 | US 2003/0104317 A1 claims | |
| JP | 58-159533 | A | 21 September 1983 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6083072 A
- JP 2010117623 A